# EUROPEAN PATENT SPECIFICATION

(11) **EP 1 914 813 B1**
(45) Date of publication and mention of the grant of the patent: **07.06.2017**
(21) Application number: 07106325.9
(22) Date of filing: 17.04.2007
(51) Int. Cl.: H01L 33/02, H01S 5/343, B82Y 20/00, H01S 5/20, H01S 5/32, H01S 5/00, H01S 5/34, H01L 33/06, H01L 33/32

(54) **Semiconductor optoelectronic device**
Optoelektronische Halbleitervorrichtung
Dispositif optoélectronique semi-conducteur

(30) Priority: 18.10.2006 KR 20060101579
(43) Date of publication of application: 23.04.2008
(73) Proprietor: Samsung Electronics Co., Ltd., Suwon-si, Gyeonggi-do, 443-742 (KR)
(72) Inventor: Son, Joong-kon, c/o Samsung Advanced Inst. of Technology, Yongin-si, Gyeonggi-do (KR); Ryu, Han-youl, c/o Samsung Advanced Instituteof Technology, Yongin-si, Gyeonggi-do (KR); Sakong, Tan, c/o Samsung Advanced Institute of Technology, Yongin-si, Gyeonggi-do (KR); Paek, Ho-sun, c/o Samsung Advanced Institute of Technology, Yongin-si, Gyeonggi-do (KR); Lee, Sung-nam, c/o Samsung Advanced Inst. of Technology, Yongin-si, Gyeonggi-do (KR)
(74) Representative: Portch, Daniel

(56) References cited:
- EP-A1- 1 670 106
- EP-A2- 1 411 559
- JP-A- 11 074 621
- JP-A- 2002 335 052

## Description

### BACKGROUND OF THE INVENTION

The present invention relates to a semiconductor optoelectronic device, and more particularly, to a semiconductor optoelectronic device having high optical efficiency.

U.S. Pat. No. 7,058,105 discloses a semiconductor laser device, which is one kind of a nitride-based compound semiconductor opto-electronic device. Such nitride-based light emitting devices use sapphire as a material for forming a substrate. In general, a wave guide layer is formed of GaN to guide light formed in an active layer of a nitride-based laser diode. Also, a clad layer is formed of AlₓGa₁₋ₓN to confine light and electrons. AlₓGa₁₋ₓN has a larger energy gap than GaN and a larger refractive index difference from InGaN as an active layer than GaN as a waveguide. An AlGaN layer used as a clad layer has a higher lattice parameter and thermal expansion coefficient than a wave guide layer and GaN used as an n-type contact layer. Thus, cracks are formed. As a result, a composition ratio and a thickness of Al of AlₓGa₁₋ₓN are limited. According to the recent research results, a composition ratio of Al of an AlGaN/GaN super lattice is limited to about 14%, and a thickness of Al is confined to 1µm. A composition ratio of Al of bulk AlGaN is limited to 8%, and a thickness of Al is confined to 1µm. An improvement of an optical confinement effect is limited by the limited thickness of a clad layer and limited ratio of Al. In other words, an optical confinement factor (OCF) may be reduced, and a threshold current may be increased. Thus, it is difficult to improve the internal quantum efficiency and optical power of a semiconductor opto-electronic device.

EP 1 411 559 describes a semiconductor device with upper and lower optical confinement layers above and below an active layer. Waveguide layers are also provided.

### SUMMARY OF THE INVENTION

According to an aspect of the present invention, there is provided a semiconductor opto-electronic device according to claim 1.

The present invention may provide a semiconductor opto-electronic device capable of effectively increasing an optical confinement factor (OCF) and reducing an internal loss to improve internal quantum efficiency and reliability.

The present invention may provide a highly efficient semiconductor opto-electronic device capable of increasing an optical gain to reduce a threshold current of a laser so as to reduce an operation input power.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a semiconductor laser device having a stack structure according to an embodiment of the present invention;
FIG. 2 is a graph illustrating an energy gap of each crystal layer of the semiconductor laser device illustrated in FIG. 1;
FIG. 3 is a graph illustrating variations of an optical confinement factor (OCF) with respect to increases of 1.5%, 3%, and 4% in a composition ratio of In of a lower optical confinement layer (OCL);
FIG. 4 is a graph illustrating variations of an internal loss with respect to the increases of 1.5%, 3%, 4% in the composition ratio of In of the lower OCL;
FIG. 5 is a graph illustrating variations in a gain threshold value with respect to the increases of 1.5%, 3%, 4% in the composition ratio of In of the lower OCL;
FIG. 6 is a graph illustrating variations and differences in a peak wavelength with respect to variations in an excitation power when the composition ratio of In of the lower OCL is 1.5% and 4%, respectively.

### DETAILED DESCRIPTION OF THE INVENTION

A semiconductor opto-electronic device according to the present invention increases an optical confinement factor (OCF) and reduces an internal loss in a structure of a clad layer having a maximum Al composition, and cracks are not formed in the clad layer. Thus, the semiconductor opto-electronic device includes upper and lower optical confinement layers (OCLs) which have energy gap values between an active layer and upper and lower wave guide layers to increase an optical gain. Also, the semiconductor opto-electronic device has a structure including the upper and lower OCLs. The upper OCL has an energy gap smaller than an upper wave guide layer and equal to or larger than a barrier layer. The lower OCL has an energy gap smaller than a lower wave guide layer and equal to or smaller than the barrier layer. The semiconductor opto-electronic device having the above-described structure increases internal quantum efficiency and reduces a threshold current and an operation input power. This will be described later. The reductions in the threshold current and the operation input power contribute to increasing the oscillation efficiency and extending the lifespan of the semiconductor opto-electronic device. In addition, an incorporation ratio of In is increased, and a strain of a quantum well is reduced. Thus, a long wavelength laser having a reduced blue shift can be oscillated.

Moreover, an effect of a piezoelectric field generated by the strain of the quantum well is reduced. Thus, a blue shift is small with respect to an excitation power when a semiconductor laser has a long wavelength of 450nm or more. As a result, a long wavelength semiconductor laser device can be obtained.

The semiconductor opto-electronic device of the present invention may be a nitride-based opto-electronice device that can be used as a light emitting and receiving device.

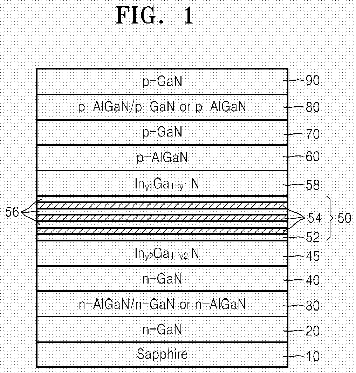

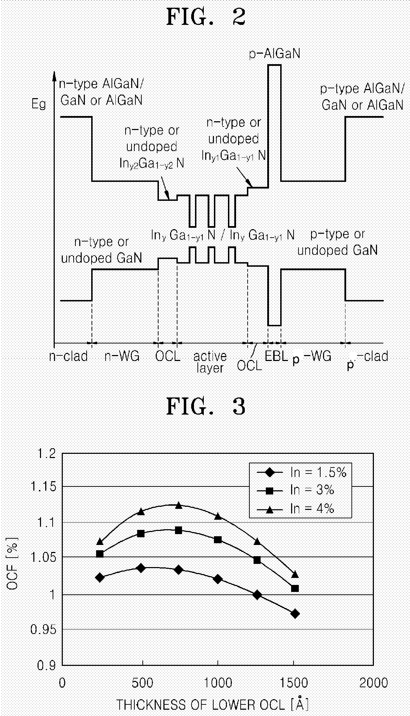

FIG. 1 is a cross-sectional view of a semiconductor laser device having a stack structure according to an embodiment of the present invention, and FIG. 2 is a graph illustrating an energy gap of each crystal layer of the semiconductor laser device illustrated in FIG. 1.

Referring to FIG. 1, a GaN contact layer 20 doped with Si is formed on a substrate 10 formed of Si, SiC, GaN, or sapphire. An electroluminescent layer including an InGaN active layer 50 as a main element is formed on the GaN contact layer 20.

The InGaN active layer 50 includes quantum wells 54 formed of AlᵥInₓGa₁₋ₓ₋ᵥN (0≤v,x≤1, 0≤x+v≤1) and barrier layers 52 and 56 formed of Al_{w}In_{y}Ga_{1-y-w}N (0≤w,y≤1, 0≤y+w≤1). In the InGaN active layer 50, a composition ratio of In of the quantum wells 54 is equal to or higher than a composition ratio of In of the barrier layers 52 and 56. A composition ratio of Al of the quantum wells 54 is equal to or lower than a composition ratio of Al of the barrier layers 52 and 56. The InGaN active layer 50 may include multi-quantum wells or a single quantum well.

Lower and upper OCLs 45 and 58 are asymmetrically formed on and underneath the InGaN active layer 50, respectively. For example, the upper OCL 58 may be formed of Alₓ₁In_{y1}Ga_{1-x1-y1}N (0≤x1, y1≤ 1, 0≤x1+y1≤1) which is doped with p-type doant or is not doped, and the lower OCL 45 may be formed of Alₓ₂In_{y2}Ga_{1-x2-y2}N (0≤x2, y2≤ 1, 0≤x2+y2≤1) which is doped with an n-type dopant or is not dopant. As to energy gaps of the upper and lower OCLs 58 and 48, a composition ratio of In of the lower OCL 45 is larger than a composition ratio of In of the upper OCL 58 as shown in FIG. 2, i.e., y1< y2. In detail, the upper OCL 58 has an energy gap smaller than an energy gap of an upper waveguide layer 70 and larger than energy gaps of the barrier layers 52 and 56. The lower OCL 45 has an energy gap smaller than a lower wave guide layer 40 and equal to or smaller than the energy gaps of the barrier layers 52 and 56.

According to another aspect of the present invention, the energy gap of the barrier layer 52 of the InGaN active layer 50, the closest to the OCL 45, may be smaller than the energy gap of the other barrier layer 56. Also, the energy gap of the lower OCL 45 may be equal to the energy gap of the barrier layer 52.

The semiconductor opto-electronic device of the present invention may further include a buffer layer (not shown) between the lower OCL 45 and the lower wave guide layer 40. An energy gap of the buffer layer may have a value within a range between the energy gap of the lower OCL 45 and the energy gap of the lower wave guide layer 30.

The upper and lower OCLs 58 and 45 of the semiconductor opto-electronic device of the present invention may be doped with Si or Mg. The upper and lower OCLs 58 and 45 may each have a thickness between 10 nm and 200 nm (100 Å and 2000 Å). The upper and lower wave guide layers 70 and 40 of FIG. 1 are formed of P-GaN and n-GaN, respectively. Alternatively, the upper and lower wave guide layers 70 and 40 may be formed of p-Al_{z}Ga_{1-z}N (0≤z≤0.5) and n-Al_{z}Ga_{1-z}N (0≤z≤0.5), respectively. The upper and lower wave guide layers 70 and 40 have larger energy gaps than the upper and lower OCLs 58 and 45. Also, a clad layer 30 and a contact layer 20 are sequentially formed underneath the lower waveguide layer 40. Here, the clad layer 30 is formed of n-AlGaN/n-GaN, n-AlGaN/GaN, AlGaN/n-GaN, or n-AlGaN, and the contact layer 20 is formed of n-GaN. Composition ratios of Al of the upper and lower waveguide layers 70 and 40 must be lower than composition ratios of Al of upper and lower clad layers 80 and 30.

An encapsulated barrier layer (EBL) 60 is interposed between the upper OCL 58 and the upper waveguide layer 70. The EBL 60 is formed of p-AlGaN. As shown in FIG. 3, the EBL 60 has the largest energy gap from among the other crystalline layers. Thus, the EBL 60 prevents electrons from overflowing but allows only holes to pass.

The upper clad layer 80 and an upper contact layer 90 are sequentially formed on the upper waveguide layer 70. The upper clad layer 80 is formed of p-AlGaN/p-GaN, p-AlGaN/GaN, AlGaN/p-GaN, or p-AlGaN, and the upper contact layer 90 is formed of p-GaN.

According to the present invention in which the upper and lower OCLs 58 and 48 are provided at both sides of an active layer, although a composition of Al and a thickness of an AlGaN clad layer are limited, an OCF is increased, and an internal loss is reduced. Thus, a gain threshold value is minimized. As a result, a threshold current and the internal quantum efficiency of the semiconductor opto-electronic device are improved.

According to the present invention, a structure including upper and lower waveguide layers and the upper and lower OCLs 58 and 45 can be used, wherein the upper and lower OCLs 58 and 45 have upper and lower energy gaps narrower than the energy gaps of the upper and lower waveguide layers and are asymmetric to each other. Thus, a double optical confinement effect and an incorporation ratio of In of the quantum well 54 of the active layer 50 can be improved. In addition, a quantum well is slightly strained to reduce a blue shift when an oscillation device having a long wavelength of 450nm or more is fabricated. Thus, a long wavelength laser can be fabricated.

FIG. 3 is a graph illustrating variations of an OCF with respect to increases of 1.5%, 3%, and 4% in a composition ratio of In of the lower OCL 45. A composition ratio of In of the upper OCL 58 is fixed to 1.5%. As shown in FIG. 3, as the composition ratio of In of the lower OCL 45 is increased from 1.5% to 3% and 4%, the OCF is increased. In other words, when the composition ratios of In of the upper and lower OCLs 58 and 45 are different, i.e., their energy gaps are asymmetric to each other, the OCF is widely increased. The OCF varies with a variation in a thickness of the lower OCL 45 with respect to each composition ratio of In. When the composition of In is 4%, the OCF varies the most greatly. This is because a maximum value of an optical mode becomes closer to a center of a quantum well QW due to an increase in In of the lower OCL 45.

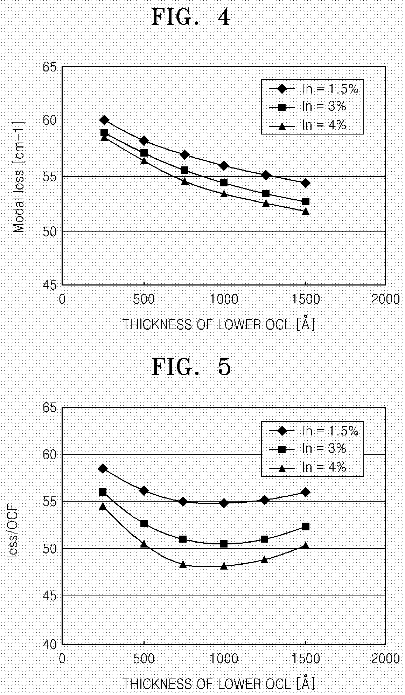

FIG. 4 is a graph illustrating variations in an internal loss ai with respect to increases of 1.5%, 3%, and 4% in the composition ratio of In of the lower OCL 45. The composition ratio of In of the upper OCL 58 is fixed to 1.5%. As shown in FIG. 4, as the composition ratio of In of the lower OCL 45 is increased from 1.5% to 3% and 4%, the internal loss is reduced. In other words, when the composition ratios of In of the upper and lower OCLs 58 and 45 are different, i.e., the energy gaps of the upper and lower OCLs 58 and 45 are asymmetric to each other, the internal loss is further reduced. This is interpreted as a phenomenon in which an optical mode inclining toward a p-GaN layer is reduced and thus an internal loss occurring in the p-GaN layer is reduced.

FIG. 5 is a graph illustrating variations in a gain threshold value with respect to increases of 1.5%, 3%, and 4% in the composition ratio of In of the lower OCL 45. As the gain threshold value is small, an oscillation characteristic of the semiconductor opto-electronic device is improved, wherein the gain threshold value is defined as a value obtained by dividing an optical loss by an OCF. When the composition of In of the lower OCL 45 is increased from 1.5% to 3% and 4% so that the upper and lower OCLs 58 and 45 are asymmetric to each other, the gain threshold value is considerably lowered.

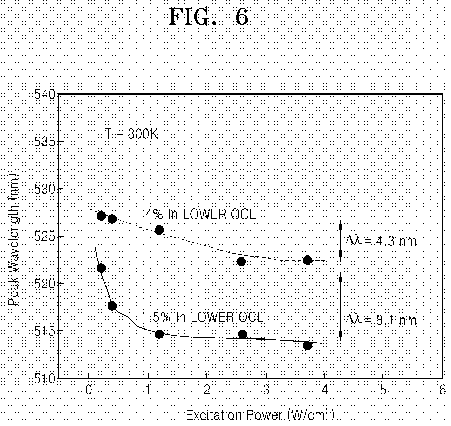

According to the above-described results, the thickness of each of the upper and lower OCLs 58 and 45 may be adjusted within a range between 10 nm and 200 nm (100 Å and 2000 Å). In detail, each of the upper and lower OCLs 58 and 45 may have a thickness between 20 nm and 120 nm (200 Å and 1200 Å). FIG. 6 is a graph illustrating variations and differences in a peak wavelength with respect to variations in an excitation power when the composition ratio of In of the lower OCL 45 is 1.5% and 4%, respectively. When the composition ratio of In of the lower OCL 45 is 4%, optical characteristic of the longer wavelength is obtained than when composition ratio of In is 1.5%. Also, when the composition ratio of In of the lower OCL 45 is 4%, the excitation power is increased. Thus, a blue shift (△ λ= 4.3 nm) occurring when the composition ratio of In is 4% is 50% smaller than a blue shift (△ λ= 8.1 nm) occurring when the composition ratio of In is 1.5%.

As described above, a semiconductor opto-electronic device according to the present invention includes upper and lower waveguide layers and upper and lower OCLs. The upper and lower OCLs have energy gaps that are narrower than energy gaps of the upper and lower waveguide layers and asymmetric to each other. Thus, a double optical confinement effect and an incorporation ratio of In of a quantum well of an active layer can be improved. In addition, an effect of a piezoelectric field generated by a strain of the quantum well can be reduced. Thus, a long wavelength semiconductor laser having a long wavelength of 450nm or more with a small blue shift with respect to an excitation power can be obtained. The semiconductor opto-electronic device according to the present invention can be applied to nitride-based light emitting and receiving devices. In other words, the semiconductor opto-electronic device of the present invention can be applied to white, blue, and green LEDs as nitride-based light emitting devices, ultraviolet, violet, blue, and green LDs, a light receiving device, an electronic device, etc.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A semiconductor opto-electronic device comprising:
an active layer (50) comprising a quantum well (54) and a barrier layer (52,56);
upper and lower waveguide layers (70,40) formed on and underneath the active layer, respectively;
upper and lower clad layers (80,30) formed on and underneath the upper and lower waveguide layers, respectively;
a substrate (10) supporting the resultant stack structure;
an upper OCL (55),optical confinement layer, provided between the active layer and the upper waveguide layer (70), the upper OCL (55) having an energy gap smaller than an energy gap of the upper waveguide layer and equal to or larger than an energy gap of the barrier layer; and
a lower OCL (45) provided between the active layer (50) and the lower waveguide layer (40), the lower OCL (45) having an energy gap smaller than an energy gap of the lower waveguide layer and equal to or smaller than the energy gap of the barrier layer;
wherein composition ratios of Al in the upper and lower waveguide layers (70,40) are lower than in the composition ratios of Al in the upper and lower clad layers (80,30);
wherein the upper OCL (55) is formed of Alₓ₁In_{y1}Ga_{1-x1-y1}N (0≤x1, y1≤ 1, 0≤x1+y1≤1), the lower OCL (45) is formed of Alₓ₂In_{y2}Ga_{1-x2-y2}N (0≤x2, y2≤ 1, 0≤x2+y2≤1),
wherein each of the upper and lower OCLs (55,45) has a thickness between 20 nm (200 Å) and 120 nm (1200 Å),
**characterised in that** a composition ratio of In of the lower OCL is larger than a composition ratio of In of the upper OCL.

2. The semiconductor opto-electronic device of claim 1, wherein an electron blocking layer (60) is interposed between the upper waveguide layer (70) and the upper OCL (55) formed underneath the upper waveguide layer.

3. The semiconductor opto-electronic device of claim 1 or 2, wherein the substrate (10) is formed of one of Si, sapphire, SiC, and GaN.

4. The semiconductor opto-electronic device of any preceding claim, wherein the upper and lower waveguide layers (70,40) are formed of p-Al_{z}Ga_{1-z}N (0≤z≤0.5) and n-Al_{z}Ga_{1-z}N (0≤z≤0.5), respectively, the upper and lower clad layers are formed of p-AlGaN/p-GaN and n-AlGaN/n-GaN, or p-AlGaN and n-AlGaN, respectively, the quantum well is formed of AlᵥInₓGa₁₋ₓ₋ᵥN (0≤v,x≤1, 0≤x+v≤1), and the barrier layer is formed of Al_{w}In_{y}Ga_{1-y-w}N (0≤w,y≤1, 0≤y+w≤1, y≤x, v≤w).

5. The semiconductor opto-electronic device of any preceding claim, wherein the active layer (50) comprises multi-quantum well layers (54).

6. The semiconductor opto-electronic device of claim 5, wherein the energy gap of the barrier layer (52) of the active layer closest to the lower OCL is smaller than an energy gap of another barrier layer (56), and the energy gap of the lower OCL (45) is equal to the energy gap of the another barrier layer (56).

7. The semiconductor opto-electronic device of any preceding claim, further comprising a buffer layer interposed between the lower OCL (45) and the lower waveguide layer (40), wherein an energy gap of the buffer layer has a value within a range between the energy gaps of the lower OCL and the lower waveguide layer.

8. The semiconductor opto-electronic device of any preceding claim, wherein the upper and lower OCLs (55,45) are doped with one of Si and Mg.

9. The semiconductor opto-electronic device of any preceding claim, wherein thicknesses of the upper and lower OCLs (55,45) are different from each other.

## Patentansprüche

1. Optoelektronische Halbleitervorrichtung, die Folgendes umfasst:
eine aktive Schicht (50), die einen Quantentopf (54) und eine Sperrschicht (52,56) umfasst;
eine obere und eine untere Wellenleiterschicht (70,40), die auf bzw. unterhalb der aktiven Schicht gebildet sind;
eine obere und eine untere Mantelschicht (80,30), die auf bzw. unterhalb der oberen bzw. der unteren Wellenleiterschicht gebildet sind;
ein Substrat (10), das die resultierende Stapelstruktur stützt;
eine obere OCL (55), optische Begrenzungsschicht, die zwischen der aktiven Schicht und der oberen Wellenleiterschicht (70) bereitgestellt ist, wobei die obere OCL (55) eine Energielücke aufweist, die kleiner als eine Energielücke der oberen Wellenleiterschicht und genauso groß wie oder größer als eine Energielücke der Sperrschicht ist; und
eine untere OCL (45), die zwischen der aktiven Schicht (50) und der unteren Wellenleiterschicht (40) bereitgestellt ist, wobei die untere OCL (45) eine Energielücke aufweist, die kleiner als eine Energielücke der unteren Wellenleiterschicht und genauso groß wie oder kleiner als eine Energielücke der Sperrschicht ist;
wobei die Zusammensetzungsverhältnisse von Al in der oberen und der unteren Wellenleiterschicht (70,40) niedriger als in den Zusammensetzungverhältnissen von Al in der oberen und der unteren Mantelschicht (80,30) sind;
wobei die obere OCL (55) aus Alₓ₁In_{y1}Ga_{1-x-y1}N (0≤x1, y1≤ 1, 0≤x1+y1≤1) gebildet ist, die untere OCL (45) aus Alₓ₂In_{y2}Ga_{1-x2-y2}N (0≤x2, y2≤ 1, 0≤x2+y2≤1) gebildet ist,
wobei jede der oberen und der unteren OCL (55,45) eine Dicke zwischen 20 nm (200 Å) und 120 nm (1200 Å) aufweist,
**dadurch gekennzeichnet, dass** ein Zusammensetzungsverhältnis von In der unteren OCL höher als ein Zusammensetzungsverhältnis von In der oberen OCL ist.

2. Optoelektronische Halbleitervorrichtung nach Anspruch 1, wobei eine Elektronensperrschicht (60) zwischen der oberen Wellenleiterschicht (70) und der oberen, unter der oberen Wellenleiterschicht gebildeten OCL (55) angeordnet ist.

3. Optoelektronische Halbleitervorrichtung nach Anspruch 1 oder 2, wobei das Substrat (10) aus einem von Si, Saphir, SiC und GaN gebildet ist.

4. Optoelektronische Halbleitervorrichtung nach einem der vorhergehenden Ansprüche, wobei die obere und die untere Wellenleiterschicht (70,40) aus p-Al_{z}Ga_{1-z}N (0≤z≤0,5) bzw. n-Al_{z}Ga_{1-z}N (0≤z≤0,5) gebildet sind, die obere und die untere Mantelschicht aus p-AlGaN/p-GaN bzw. n-AlGaN/n-GaN, oder p-AlGaN bzw. n-AlGaN gebildet sind, der Quantentopf aus AlᵥInₓGa₁₋ₓ₋ᵥN (0≤v,x≤1, 0≤x+v≤1) gebildet ist und die Sperrschicht aus Al_{w}In_{y}Ga_{1-y-w}N (0≤w,y≤1, 0≤y+w≤1, y≤x, v≤w) gebildet ist.

5. Optoelektronische Halbleitervorrichtung nach einem der vorhergehenden Ansprüche, wobei die aktive Schicht (50) Mehrfachquantentopfschichten (54) umfasst.

6. Optoelektronische Halbleitervorrichtung nach Anspruch 5, wobei die Energielücke der Sperrschicht (52) der aktiven Schicht, die der unteren OCL am nächsten ist, kleiner als eine Energielücke einer anderen Sperrschicht (56) ist, und die Energielücke der unteren OCL (45) genauso groß wie die Energielücke der anderen Sperrschicht (56) ist.

7. Optoelektronische Halbleitervorrichtung nach einem der vorhergehenden Ansprüche, die ferner eine Pufferschicht umfasst, die zwischen der unteren OCL (45) und der unteren Wellenleiterschicht (40) angeordnet ist, wobei eine Energielücke der Pufferschicht einen Wert innerhalb eines Bereichs zwischen den Energielücken der unteren OCL und der unteren Wellenleiterschicht aufweist.

8. Optoelektronische Halbleitervorrichtung nach einem der vorhergehenden Ansprüche, wobei die obere und die untere OCL (55,45) mit einem von Si und Mg dotiert sind.

9. Optoelektronische Halbleitervorrichtung nach einem der vorhergehenden Ansprüche, wobei die Dicken der oberen und der unteren OCL (55,45) voneinander verschieden sind.

## Revendications

1. Dispositif optoélectronique à semiconducteur comprenant :
une couche active (50) comprenant un puits quantique (54) et une couche barrière (52, 56) ;
des couches de guide d'ondes supérieure et inférieure (70, 40) formées sur et sous la couche active, respectivement ;
des couches de gaine supérieure et inférieure (80, 30) formées sur et sous les couches de guide d'ondes supérieure et inférieure, respectivement ;
un substrat (10) supportant la structure d'empilement résultante ;
une couche de confinement optique OCL supérieure (55), prévue entre la couche active et la couche de guide d'ondes supérieure (70), l'OCL supérieure (55) présentant un écart énergétique inférieur à un écart énergétique de la couche de guide d'ondes supérieure et égal ou supérieur à un écart énergétique de la couche barrière ; et
une OCL inférieure (45), prévue entre la couche active (50) et la couche de guide d'ondes inférieure (40), l'OCL inférieure (45) présentant un écart énergétique inférieur à un écart énergétique de la couche de guide d'ondes inférieure et égal ou inférieur à l'écart énergétique de la couche barrière ;
dans lequel des ratios de composition de Al dans les couches de guide d'ondes supérieure et inférieure (70, 40) sont inférieurs aux ratios de composition de Al dans les couches de gaine supérieure et inférieure (80, 30) ;
dans lequel l'OCL supérieure (55) est formée d'Alₓ₁In_{y1}Ga_{1-x1-y1}N (0≤x1, y1≤ 1, 0≤x1+y1≤1), l'OCL inférieure (45) est formée de Alₓ₂Iny₂Ga_{1-x2-y2}N (0≤x2, y2≤ 1, 0≤x2+y2≤1),
dans lequel chacune des OCL supérieure et inférieure (55, 45) a une épaisseur entre 20 nm (200 Å) et 120 nm (1200 Å),
**caractérisé en ce qu'**un ratio de composition de In de l'OCL inférieure est supérieure à un ratio de composition de In de l'OCL supérieure.

2. Dispositif optoélectronique à semiconducteur selon la revendication 1, dans lequel une couche de blocage d'électron (60) est interposée entre la couche de guide d'ondes supérieure (70) et l'OCL supérieure (55) formée sous la couche de guide d'ondes supérieure.

3. Dispositif optoélectronique à semiconducteur selon la revendication 1 ou 2, dans lequel le substrat (10) est formé d'un élément parmi le Si, saphir, SiC et GaN.

4. Dispositif optoélectronique à semiconducteur selon l'une quelconque des revendications précédentes, dans lequel les couches de guide d'ondes supérieure et inférieure (70, 40) sont formées de p-Al_{z}Ga_{1-z}N (0≤z≤0,5) et n-Al_{z}Ga_{1-z}N (0≤z≤0,5), respectivement, les couches de gaine supérieure et inférieure sont formées de p-AlGaN/p-GaN et n-AlGaN/n-GaN, ou p-AlGaN et n-AlGaN, respectivement, le puits quantique est formé de AlᵥInₓGa₁₋ₓ₋ᵥN (0≤v,x≤1, 0≤x+v≤1), et la couche barrière est formée de Al_{w}In_{y}Ga_{1-y-w}N (0≤w,y≤1,0≤y+w≤1, y≤x, v≤w).

5. Dispositif optoélectronique à semiconducteur selon l'une quelconque des revendications précédentes, dans lequel la couche active (50) comprend des couches de multi-puits quantiques (54).

6. Dispositif optoélectronique à semiconducteur selon la revendication 5, dans lequel l'écart énergétique de la couche barrière (52) de la couche active la plus proche de l'OCL inférieure est inférieur à un écart énergétique d'une autre couche barrière (56), et l'écart énergétique de l'OCL inférieur (45) est égal à l'écart énergétique de l'autre couche barrière (56).

7. Dispositif optoélectronique à semiconducteur selon l'une quelconque des revendications précédentes, comprenant en outre une couche tampon interposée entre l'OCL inférieure (45) et la couche de guide d'ondes inférieure (40), dans lequel un écart énergétique de la couche tampon présente une valeur comprise dans une fourchette entre les écarts énergétiques de l'OCL inférieure et la couche de guide d'ondes inférieure.

8. Dispositif optoélectronique à semiconducteur selon l'une quelconque des revendications précédentes, dans lequel les OCL supérieure et inférieure (55, 45) sont dopées avec un élément parmi le Si et Mg.

9. Dispositif optoélectronique à semiconducteur selon l'une quelconque des revendications précédentes, dans lequel l'épaisseur des OCL supérieure et inférieure (55, 45) sont différentes l'une de l'autre.
